(19) Europäisches Patentamt
European Patent Office
Office européen des brevets

(11) **EP 1 271 780 B1**

(12) **EUROPÄISCHE PATENTSCHRIFT**

(45) Veröffentlichungstag und Bekanntmachung des Hinweises auf die Patenterteilung:
**13.08.2014 Patentblatt 2014/33**

(51) Int Cl.:
*H04H 20/22* (2008.01) *H04H 60/58* (2008.01)

(21) Anmeldenummer: **02013394.8**

(22) Anmeldetag: **19.06.2002**

(54) **Verfahren und Vorrichtung zum Erkennen von Sendern mit gleichem Programminhalt**

Method and device for the identification of transmitters that broadcast the same program contents

Procédé et dispositif d'identification d'émetteurs radio diffusant le même contenu de programme

(84) Benannte Vertragsstaaten:
**AT BE CH CY DE DK ES FI FR GB GR IE IT LI LU MC NL PT SE TR**

(30) Priorität: **21.06.2001 DE 10129919**

(43) Veröffentlichungstag der Anmeldung:
**02.01.2003 Patentblatt 2003/01**

(73) Patentinhaber: **Harman Becker Automotive Systems GmbH**
**76307 Karlsbad (DE)**

(72) Erfinder:
• **Gierl, Stefan, Dipl.-Ing.**
**76133 Karlsruhe (DE)**

• **Benz, Chistoph, Dipl.-Ing.**
**77797 Ohlsbach (DE)**
• **Zahn, Michael, Dipl.-Ing.**
**76337 Waldbronn (DE)**
• **Köhler, Stefan, Dipl.-Ing.**
**75210 Keltern (DE)**

(74) Vertreter: **Patentanwälte**
**Westphal, Mussgnug & Partner**
**Am Riettor 5**
**78048 Villingen-Schwenningen (DE)**

(56) Entgegenhaltungen:
**DE-A1- 3 203 591 GB-A- 2 182 435**

EP 1 271 780 B1

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

**Beschreibung**

Die vorliegende Erfindung betrifft ein Verfahren und eine Vorrichtung zum Erkennen von zwei Sendern mit gleichem Programminhalt, die auf unterschiedlichen Kanälen, insbesondere mit unterschiedlichen Funkfrequenzen, einen Empfänger erreichen. Derartige Verfahren und Vorrichtungen werden insbesondere bei Rundfunk- oder Fernsehempfängern für den mobilen Gebrauch, insbesondere für den Einbau in Kraftfahrzeugen, eingesetzt. Sie dienen dazu, wenn der Empfänger ein Gebiet, in dem ein zum Empfang eingestellter Sender empfangbar ist, verlässt, ohne Zutun eines Benutzers einen anderen Sender ausfindig zu machen, der das gleiche Programm auf einer anderen Frequenz mit besserer Empfangsqualität verbreitet, und, wenn ein solcher Sender gefunden wird, den Empfänger auf dessen Frequenz umzuschalten.

Bei FM-Rundfunkempfängern ist es bekannt, zusätzlich zum eigentlichen Programmsignal, das mit der zu übertragenden Audioinformation moduliert ist, ein als PI-Code bezeichnetes Codesignal zu übertragen, das eine Identifizierung des Betreibers des gerade empfangenen Senders und gegebenenfalls eine Unterscheidung zwischen mehreren Programmen eines gleichen Betreibers erlaubt, und das vom Empfänger ausgewertet werden kann, um zu entscheiden, ob zwei Sender ein gleiches Programm verbreiten. Im Falle eines Fernsehsignals ist eine entsprechende Entscheidung anhand eines Videotextsignals möglich, das, sofern vorhanden, begleitend zu dem die eigentliche Bild- und Toninformation enthaltenden Programmsignal ausgestrahlt wird.

Diese Techniken setzen voraus, dass die Sender zusätzlich zum eigentlichen Programmsignal unterstützende Signale ausstrahlen, die dem Empfänger eine Entscheidung über die Identität von zwei Sendern ermöglichen. Sie sind nicht anwendbar auf Sender, die derartige unterstützende Signale nicht bereitstellen.

Außerdem sind diese Techniken störanfällig, da sie jeweils nur einen winzigen Anteil der insgesamt von einem Sender ausgetrahlten Informationsmenge für eine Entscheidung über die Identität zweier Programme auswerten, so dass Fehler bei der Übertragung oder Auswertung einer Information zu einer falschen Senderidentifizierung führen können.

Ein anderer Nachteil ist, dass auch wenn diese bekannten Techniken korrekt arbeiten, sie nicht in allen Fällen eine Umschaltung auf die Frequenz desjenigen Senders ermöglichen, der den Empfang eines gegebenen Programms unter optimalen Bedingungen ermöglicht. Häufig werden nämlich Programme, insbesondere sogenannte Liveübertragungen, von Sendern unterschiedlicher Betreibergesellschaften zeitgleich übertragen. Wenn ein Benutzer eine solche Sendung verfolgt, so kann er dies nicht nur über die Sender derjenigen Betreibergesellschaft tun, auf die sein Empfänger zu einem gegebenen Zeitpunkt abgestimmt ist, sondern auch über die von anderen Betreibern, die im gleichen Gebiet, möglicherweise mit besserer Qualität, empfangbar sein können. Eine automatische Umschaltung auf deren Sender erlauben die herkömmlichen Techniken nicht.

Die Druckschrift DE 32 03 591 A1 beschreibt ein Autoradio mit automatischer Empfangsfrequenzumschaltung, wobei unter Verwendung von Korrelationsverfahren automatisch der jeweils stärkste Sender mit dem gleichen Programm gesucht und eingestellt wird.

Eine erste Aufgabe der vorliegenden Erfindung ist, ein Verfahren und eine Vorrichtung zum Erkennen von zwei Sendern mit gleichen Programminhalten zu schaffen, die für beliebige Sender anwendbar sind, unabhängig davon, ob diese neben dem Programmsignal ein zusätzliches, eine Identitätsentscheidung unterstützendes Signal ausstrahlen oder nicht.

Eine zweite Aufgabe der Erfindung ist, ein Verfahren und eine Vorrichtung zum Erkennen von Sendern mit gleichem Programminhalt zu schaffen, die äußerst unempfindlich gegen Störungen sind.

Eine dritte Aufgabe der Erfindung ist, ein Verfahren und eine Vorrichtung zum Erkennen von Sendern mit gleichem Programminhalt zu schaffen, mit denen die Identität von Programminhalten auch dann feststellbar ist, wenn sie von zwei Sendern ausgestrahlt werden, die unterschiedlichen Betreibergesellschaften angehören.

Diese Aufgaben werden gelöst durch ein Verfahren gemäss Patentanspruch 1, bei dem die von den zwei Sendern empfangenen Signale ins Basisband transformiert werden, ein Ähnlichkeitsgrad der zeitlichen Verläufe der zwei transformierten Signale berechnet wird und zwei Sender dann als identisch erkannt werden, wenn der berechnete Ähnlichkeitsgrad einen Grenzwert übersteigt.

Vorzugsweise ist das Berechnen des Ähnlichkeitsgrades das Berechnen eines Kreuzkorrelationskoeffizienten der zeitlichen Verläufe der transformierten Signale.

Um die von den zwei Sendern ausgestrahlten Programme auch dann als identisch erkennen zu können, wenn sie den Empfänger mit einer gewissen Zeitverschiebung erreichen, die auf Laufzeitdifferenzen der Sendesignale von einer die Sendesignale liefernden Quelle zu den zwei Sendern bzw. von den Sendern zum Empfänger zurückgehen können, ist es zweckmäßig, eine Mehrzahl von Werten des Ähnlichkeitsgrades jeweils unter Zugrundelegung unterschiedlicher Zeitverschiebungen zwischen den empfangenen Signalen zu berechnen und für die Entscheidung über die Identität oder Nichtidentität der Sender den größten der dabei erhaltenen Werte der Ähnlichkeitsgrade heranzuziehen.

Für die Berechnung des Ähnlichkeitsgrades wird zweckmäßigerweise jeweils ein Satz von Abtastwerten der zwei transformierten Signale herangezogen, die den zeitlichen Verlauf der Signale jeweils über eine Zeitspanne charakterisieren, die wenigstens so groß ist wie eine erwartete maximale Zeitverschiebung zwischen den Signalen. Als maximale Zeitverschiebung kann ein Wert von z.B. 100 ms herangezogen werden.

Um den Rechenaufwand bei der Bewertung der Ähnlichkeit zu reduzieren, wird vorgeschlagen, die zwei Sätze jeweils in eine Mehrzahl von Teilsätzen zu unterteilen und die Ähnlichkeitswerte jeweils zu ermitteln durch Berechnen eines Ähnlichkeitsgrades eines Teilsatzes des ersten Signals und eines Teilsatzes des zweiten Signals. Dies geschieht zweckmäßigerweise für alle Kombinationen von Teilsätzen, die gebildet werden können.

Vor dem Berechnen des Ähnlichkeitsgrades ist es zweckmäßig, eine Bandpassfilterung der transformierten Signale durchzuführen. Eine solche Bandpassfilterung sollte z.B. wenn das Programmsignal ein Fernsehsignal ist, Spektralanteile unterdrücken, die allen Fernsehsignalen unabhängig von der in ihnen dargestellten Bildinformation gemeinsam sind, wie etwa Bild- und Zeilenfrequenzen. Die Breite des ausgefilterten Bandes kann allein unter dem Gesichtspunkt der Vereinfachung der nachfolgenden Signalverarbeitung festgelegt werden; eine Breite des Durchgangsbandes von 500 Hz ist für die Zwecke der Erfindung völlig ausreichend.

Das Durchgangsband kann eine untere Grenzfrequenz von 0 aufweisen, d.h. die Bandpassfilterung kann eine Tiefpassfilterung sein.

Dies erlaubt es, die Rate, mit der die Signale nach der Filterung weiterverarbeitet werden, auf einen Wert zu begrenzen, der der Breite des Durchgangsbandes der Filterung entspricht.

Um die Zuverlässigkeit einer Entscheidung über die Identität von zwei Programmen zu verbessern, ist es zweckmäßig, den berechneten Ähnlichkeitsgrad zeitlich zu mitteln, bevor er für eine Entscheidung über die Identität von zwei Sendern herangezogen wird. Diese Mittlung ist in einfacher Weise als Tiefpassfilterung realisierbar.

Eine weitere, die Zuverlässigkeit verbessernde Maßnahme ist die Verwendung eines Zählers, der jedes Mal, wenn der Ähnlichkeitswert einen ersten Grenzwert übersteigt, inkrementiert wird, und der mit einer festgelegten Periode dekrementiert wird. Wenn die Programme der zwei Sender identisch sind, und innerhalb der festgelegten Periode im Mittel mehr als einmal der Ähnlichkeitsgrad berechnet wird, oder wenn das Ausmaß an Inkrementierung im Mittel größer als das der Dekrementierung ist, divergiert der Stand dieses Zählers, wohingegen er im Falle der Nichtidentität der Sender nahe 0 liegen wird. Es kann daher ein zweiter Grenzwert definiert werden, und zwei Sender werden dann als identisch erkannt, wenn der Stand des Zählers diesen zweiten Grenzwert übersteigt.

Die oben genannten Aufgaben werden auch gelöst durch eine Vorrichtung gemäss Patentanspruch 10.

Die Vorrichtung ist vorzugsweise in einen Empfänger für Rundfunk- oder Fernsehsignale eingebaut, wobei ihr Demodulator zweckmäßigerweise mit dem des Empfängers identisch ist.

Weitere Merkmale und Vorteile der Erfindung ergeben sich aus der nachfolgenden Beschreibung von Ausführungsbeispielen mit Bezug auf die beigefügten Figuren. Es zeigen:

Fig. 1 ein schematisches Blockdiagramm eines mit einer erfindungsgemäßen Vorrichtung ausgerüsteten Funkempfängers;

Fig. 2 ein Blockdiagramm des Komparators und der Logikschaltung der erfindungsgemäßen Vorrichtung; und

Fig. 3 eine schematische Darstellung einer von dem Komparator berechneten Ähnlichkeitsmatrix.

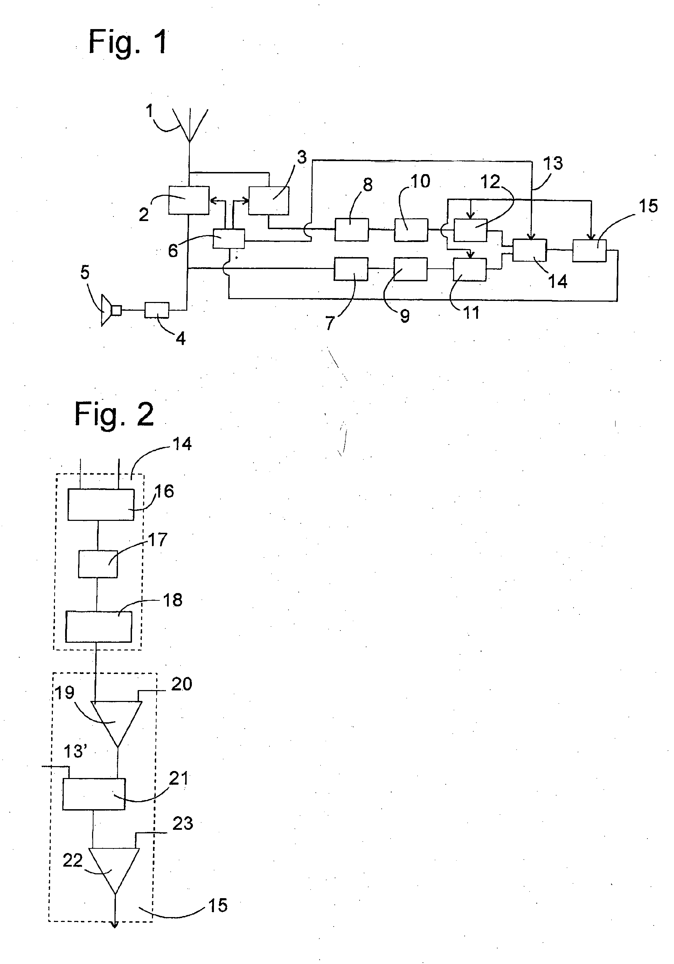

Fig. 1 veranschaulicht die Erfindung am Beispiel ihrer Anwendung auf einen Rundfunkempfänger. An eine Antenne 1 des Empfängers sind zwei Empfangsteile oder Demodulatoren 2, 3 angeschlossen, von denen der erste 2 auf die Frequenz eines Senders abgestimmt ist, dessen Funksignal, hier als Hörsignal bezeichnet, er ins Basisband transformiert und an einen Verstärker 4 zur Ausgabe über einen Lautsprecher 5 weitergibt. Der zweite Demodulator 3 wird unter der Kontrolle einer Steuereinheit 6 auf wechselnde Frequenzen abgestimmt, um zu ermitteln, ob ein auf einer solchen Frequenz, im folgenden als Untersuchungsfrequenz bezeichnet, empfangenes Signal mit dem Hörsignal identisch ist und eventuell eine bessere Empfangsqualität bietet.

Die von den zwei Demodulatoren 2, 3 ins Basisband transformierten Hörfrequenz- und Untersuchungsfrequenzsignale werden jeweils einem Tiefpassfilter 7, 8 zugeführt. Diese Tiefpassfilter 7, 8 sind baugleich; vorzugsweise sind sie auch auf einem gemeinsamen Halbleiterchip integriert, um sicherzustellen, dass eventuelle Temperaturdriften sich auf das Durchlassverhalten beider Tiefpassfilter 7, 8 in gleicher Weise auswirken. Die Tiefpassfilter haben eine obere Grenzfrequenz von 500 Hz. Der Frequenzbereich von 0 bis 500 Hz ist zwar nur ein kleiner Anteil des vom menschlichen Gehör wahrnehmbaren Frequenzbereichs, allerdings enthält dieser Frequenzbereich ausreichend Information, um die Gleichheit bzw. Ungleichheit zweier Audiosignale beurteilen zu können.

Die Tiefpassfilter 7, 8 unterdrücken auch ein PI-Codesignal, das in dem Hörfrequenzsignal oder dem Untersuchungsfrequenzsignal möglicherweise enthalten ist. Daraus resultiert, dass die durch die Tiefpassfilter 7, 8 gefilterten Signale insbesondere auch dann identisch sein können, wenn ein gleicher Programminhalt zeitgleich von zwei Sendern ausgestrahlt wird, die unterschiedliche PI-Codes verwenden.

Während das von den Demodulatoren 2, 3 gelieferte Basisbandsignal ein analoges Signal oder ein digitales Signal mit einer Abtastfrequenz von typischerweise ca. 44 kHz sein kann, genügt für die Weiterverarbeitung der Ausgangssignale der Tiefpassfilter 7, 8 eine Verarbeitungsfrequenz, die dem Doppelten der oberen Grenzfrequenz der Tiefpassfilters 7, 8, also 1000 Hz entspricht. Es ist daher an den Ausgang jedes Tiefpassfilters 7, 8 jeweils eine Abtastschaltung 9, 10 angeschlossen, die in dem Fall, dass die Demodulatoren 2, 3 ein analoges Signal liefern, einen mit einer Abtastfrequenz von 1 kHz betriebenen Analog-Digital-Wandler enthält und in dem Fall, dass die Demodulatoren 2, 3 ein digitales Ausgangssignal liefern, eine Reduktion von dessen Datenrate auf 1 kHz vornehmen.

An den Ausgang jeder Abtastschaltung 9, 10 ist ein Pufferspeicher 11 bzw. 12 angeschlossen, der bei der hier als Beispiel beschriebenen Ausgestaltung eine Speicherkapazität von jeweils L=112 Abtastwerten hat. Diese Pufferspeicher werden, getriggert durch ein externes Taktsignal 13, periodisch mit 112 aufeinanderfolgend von den Abtastschaltungen 9, 10 gelieferten Abtastwerten beschrieben. Das Triggersignal kann z.B. periodisch von der Steuereinheit 6 geliefert werden.

Bei der Abtastfrequenz von 1kHz entsprechen die in den Pufferspeichern 11, 12 gespeicherten Signalverläufe jeweils Zeitspannen von 112 ms. Wenn man annimmt, dass zwei inhaltlich identische, von verschiedenen Sendern ausgestrahlte Signale eine maximale Zeitverschiebung am Empfänger von 100 ms aufweisen können, so müssen die in den Pufferspeichern gespeicherten Signalverläufe auf einer Zeitspanne von mindestens 12 ms übereinstimmen.

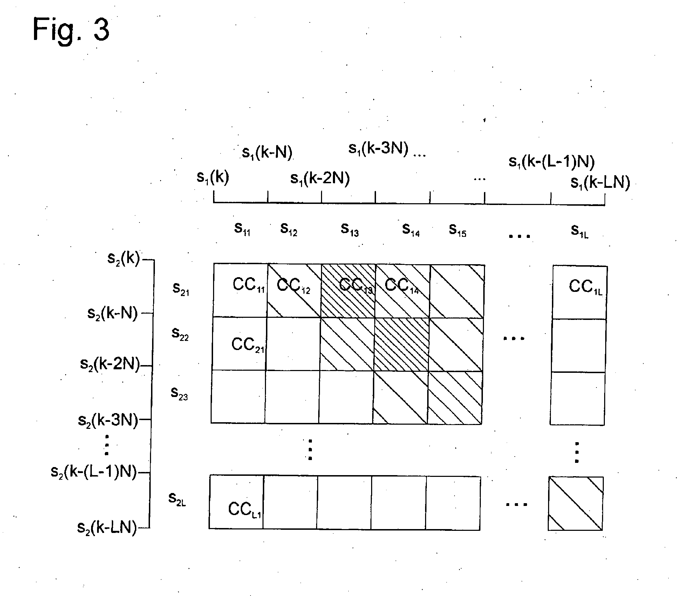

An die Ausgänge der zwei Pufferspeicher 11, 12 ist ein Komparator 14 angeschlossen, der zum Berechnen eines Ähnlichkeitsgrades der in den Pufferspeichern 11, 12 gespeicherten zeitlichen Verläufe der abgetasteten Signale dient. Seine Struktur und Arbeitsweise sowie die einer Logikschaltung 15, die an den Ausgang des Komparators 14 angeschlossen ist, werden im folgenden anhand der Figs. 2 und 3 genauer erläutert. Es wird angenommen, dass ein Triggersignal 13 erzeugt wird, nachdem in den Pufferspeichern 11, 12 Abtastwerte $s_1(k-LN+1)$ bis $s_1(k)$ des vom Demodulator 2 verarbeiteten Hörfrequenzsignals und Abtastwerte $s_2(k-LN+1)$ bis $s_2(k)$ des vom Demodulator 3 verarbeiteten Untersuchungsfrequenzsignals aufgezeichnet worden sind, wobei $s_m(k)$ (m=1,2) den zeitlich jüngsten Abtastwert der zwei Signale bezeichnet und L, N ganze Zahlen und (LN) die Zahl der Speicherplätze der Pufferspeicher 11, 12, hier also gleich 112 ist.

Wie anhand der horizontalen und vertikalen Achsen in Fig. 3 symbolisch dargestellt, werden die Abtastwerte des Hörfrequenzsignals und des Abtastfrequenzsignals in L Segmente $\mathbf{s}_{1i}$, $\mathbf{s}_{2l}$ mit i,l=1,2 .... L unterteilt, wobei jedes dieser Segmente $\mathbf{s}_{ml}$ jeweils als ein aus den Abtastwerten $\mathbf{s}_m(klN+1)$, $\mathbf{s}_m(k-lN+2, ...)$, $\mathbf{s}_m(k-lN+N)$ gebildeter Vektor aufgefasst werden kann.

Für jedes der so erhaltenen Paare von Segmenten $\mathbf{s}_{1i}$, $\mathbf{s}_{2l}$ eines Signals berechnet der Komparator 14 einen Kreuzkorrelationswert $CC_{il}$ nach der Formel

$$CC_{il} = \frac{e_{12}^{\,2}(i,l)}{e_1(i)\,e_2(l)} \quad , \tag{1}$$

wobei

$$e_1(i) = \frac{1}{N}\mathbf{s}_{1i}\cdot\mathbf{s}_{1i} \tag{2}$$

$$e_2(l) = \frac{1}{N}\mathbf{s}_{2l}\cdot\mathbf{s}_{2l} \tag{3}$$

$$e_{12}(i,l) = \frac{1}{N}\mathbf{s}_{1i}\cdot\mathbf{s}_{2l} \tag{4}$$

Die Matrix in Fig. 3 zeigt in schematischer Form ein Beispiel für das Ergebnis der Berechnung der Kreuzkorrelationswerte $CC_{ij}$, wobei jedes Kästchen der Matrix einem Kreuzkorrelationswert $CC_{ij}$ entspricht und die Dichte der Schraffur der einzelnen Kästchen ein Maß für dessen Betrag ist. Bei dem hier gezeigten Beispiel weisen die den Kreuz-

korrelationswerten $CC_{13}$ und $CC_{24}$ entsprechenden Kästchen die dichteste Schraffur auf, was einer zeitlichen Verschiebung der zwei Signale um zwei Segmente mit je N Abtastwerten, bei einer Tastfrequenz von 1 kHz also einer Zeitverschiebung von 2N Millisekunden entspricht. Weitere, in dem Diagramm nicht dargestellte hohe Kreuzkorrelationswerte könnten auf der gleichen Diagonalen wie die Werte $CC_{13}$, $CC_{24}$ liegen.

Der Komparator 14 umfasst eine Rechenschaltung 16, ein Auswahlglied 17 und ein Tiefpassfilter 18. Die Rechenschaltung 16 liefert die Gesamtheit dieser Kreuzkorrelationswerte $CC_{ij}$ an das Auswahlglied 17, das den größten dieser Werte beibehält und an das Tiefpassfilter 18 weitergibt.

Aufgabe des Tiefpassfilters 18 ist, hohe Korrelationswerte, die sich vereinzelt aus zufälligen Übereinstimmungen einzelner Segmente ergeben, und hinter denen keine inhaltliche Identität der empfangenen Signale steht, zu unterdrücken.

Zu dem gleichen Zweck könnte auch eine Anordnung von Tiefpassfiltern, die für jedes Element der Matrix aus Fig. 3 ein Tiefpassfilter umfasst, direkt an den Ausgang der Rechenschaltung 16 zum Tiefpassfiltern der einzelnen Kreuzkorrelationswerte $CC_{ij}$ angeschlossen sein und das Auswahlglied erst an die Ausgänge dieser Tiefpassfilter angeschlossen sein, um unter deren Ausgangssignalen das größte zu selektieren.

Das durch Auswahl des größten Wertes und Tiefpassfilterung erhaltene Signal wird an einen Eingang der Logikschaltung 15 angelegt. Diese umfasst einen Komparator 19, der einen Vergleich mit einem festen ersten Grenzwert 20 vornimmt. Ist das Signal größer als der erste Grenzwert, so liefert der Komparator 19 einen Ausgangspuls, mit dem ein Ereigniszähler 21 inkrementiert wird. Parallel dazu wird der Ereigniszähler 21 mit einem vom Triggersignal 13 abgeleiteten, periodischen gepulsten Signal 13' dekrementiert. Dabei ist die Periode des Signals 13' im Mittel geringfügig länger als die des Triggersignals 13, so dass in dem Fall, dass die zwei von den Demodulatoren empfangenen Funksignale identische Inhalte haben, der Inhalt des Zählers 21 im Laufe der Zeit bei wiederholter Durchführung der oben beschriebenen Schritte auch dann anwächst, wenn nicht in jedem Arbeitszyklus der Vorrichtung der Schwellwert des Komparators 19 überschritten wird. Wenn keine inhaltliche Übereinstimmung zwischen den von den Demodulatoren 2, 3 empfangenen Signalen besteht, empfängt der Ereigniszähler 21 keine inkrementierenden Pulse, und sein Zählerstand bleibt auf 0.

Das Signal 13' kann aus dem Triggersignal 13 auf einfache Weise erhalten werden, indem von einer gegebenen Zahl von Pulsen des Triggersignals 13 jeweils einer unterdrückt wird.

Das Zählergebnis des Ereigniszählers 21 wird an einen zweiten Komparator 22 weitergegeben, der einen Vergleich mit einem zweiten Grenzwert 23 durchführt und das Vergleichsergebnis an die Steuereinheit 6 liefert. Wenn das Vergleichsergebnis nicht nach einer vorgegebenen Anzahl von Pulsen des Triggersignals 13 eine Überschreitung des zweiten Grenzwerts anzeigt, so erkennt die Steuereinheit 6 daran, dass das Untersuchungsfrequenzsignal nicht mit dem Hörfrequenzsignal identisch ist. Wenn dies der Fall ist, stimmt die Steuereinheit 6 den Demodulator 3 auf eine andere Suchfrequenz ab, und das oben beschriebene Verfahren wird wiederholt. Wenn hingegen nach der vorgegebenen Zahl von Pulsen des Triggersignals 13 der zweite Komparator 22 eine Überschreitung des zweiten Grenzwerts anzeigt, so bedeutet dies, dass das Untersuchungsfrequenzsignal mit dem Hörfrequenzsignal inhaltlich identisch ist, und die Steuereinheit 6 kann, wenn das Untersuchungsfrequenzsignal einen besseren Empfang ermöglicht als das Hörfrequenzsignal, den Demodulator 2 auf die Untersuchungsfrequenz umstimmen, um so den Empfang zu verbessern.

**Patentansprüche**

1. Verfahren zum Erkennen von zwei Sendern mit gleichem Programminhalt, das folgende Schritte aufweist:

   a) Transformierten von zwei von den Sendern empfangenen Signalen ins Basisband,
   b) Berechnen eines Ähnlichkeitsgrades der zeitlichen Verläufe der zwei transformierten Signale,
   c) Erkennen von zwei Sendern als identisch, wenn der berechnete Ähnlichkeitsgrad einen Grenzwert übersteigt,

   wobei vor Durchführung des Schrittes c) der berechnete Ähnlichkeitsgrad ($CC_{ij}$) einer Mittelung über eine Mehrzahl von Wiederholungen des Schrittes b) unterzogen wird, **dadurch gekennzeichnet, dass** in Schritt c) jedes Mal, wenn der Ähnlichkeitsgrad ($CC_{ij}$) einen ersten Grenzwert übersteigt, ein Zähler (21) inkrementiert wird, dass der Zähler (21) mit einer festgelegten Periode dekrementiert wird, und dass zwei Sender nur dann als identisch erkannt werden, wenn der Stand des Zählers (21) einen zweiten Grenzwert (23) übersteigt.

2. Verfahren nach Anspruch 1, **dadurch gekennzeichnet, dass** das Berechnen des Ähnlichkeitsgrades durch Berechnen eines Kreuzkorrelationskoeffizienten ($CC_{ij}$) der zeitlichen Verläufe der transformierten Signale erfolgt.

3. Verfahren nach Anspruch 1 oder 2, **dadurch gekennzeichnet, dass** in Schritt b) eine Mehrzahl von Werten des Ähnlichkeitsgrades ($CC_{ij}$) unter Zugrundelegung unterschiedlicher Zeitverschiebungen zwischen den empfangenen Signalen berechnet wird und der größte erhaltene Wert in Schritt c) verwendet wird.

4. Verfahren nach Anspruch 3, **dadurch gekennzeichnet, dass** die Mehrzahl von Werten des Ähnlichkeitsgrades ($CC_{ij}$) jeweils anhand eines Satzes von Abtastwerten ($s_1$, $s_2$) der zwei transformierten Signalen ermittelt werden, die den zeitlichen Verlauf der Signale jeweils über eine Zeitspanne charakterisieren, die wenigstens so groß ist wie eine erwartete maximale Zeitverschiebung zwischen den Signalen.

5. Verfahren nach Anspruch 4, **dadurch gekennzeichnet, dass** die zwei Sätze ($s_1$, $s_2$) in eine Mehrzahl von Teilsätzen ($s_{11}$, $s_{12}$, ..., $s_{1L}$; $s_{21}$, $s_{22}$, ..., $s_{2L}$) unterteilt werden und jeder Ähnlichkeitsgrad ($CC_{ij}$) erhalten wird durch Berechnen eines Ähnlichkeitsgrades eines Teilsatzes ($s_{11}$, $s_{12}$, ..., $s_{1L}$) des ersten Signals und eines Teilsatzes ($s_{21}$, $s_{22}$, ..., $s_{2L}$) des zweiten Signals.

6. Verfahren nach einem der vorhergehenden Ansprüche, **dadurch gekennzeichnet, dass** vor dem Schritt b) eine Bandpassfilterung der transformierten Signale durchgeführt wird.

7. Verfahren nach Anspruch 6, **dadurch gekennzeichnet, dass** die Bandpassfilterung eine Tiefpassfilterung ist.

8. Verfahren nach Anspruch 6 oder 7, **dadurch gekennzeichnet, dass** die Signale in Schritt b) mit einer Abtastrate verarbeitet werden, die der Breite des Durchgangsbandes der Filterung entspricht.

9. Verfahren nach Anspruch 1, **dadurch gekennzeichnet, dass** die Mittelung eine Tiefpassfilterung ist.

10. Vorrichtung zum Erkennen von zwei Sendern mit gleichem Programminhalt, die aufweist:

    einen Demodulator (2, 3) zum Transformieren von zwei von den Sendern empfangenen Signalen ins Basisband,
    einen Komparator (14) zum Berechnen eines Ähnlichkeitsgrades der zeitlichen Verläufe der zwei transformierten Signale, und
    eine Logikschaltung (15) zum Erkennen von zwei Sendern als identisch, wenn der berechnete Ähnlichkeitsgrad einen Grenzwert übersteigt,
    wobei der Komparator (14) eine Rechenschaltung (16) zum Berechnen von Kreuzkorrelationskoeffizienten ($CC_{ij}$) der zeitlichen Verläufe der transformierten Signale ist sowie Kreuzkorrelationskoeffizienten ($CC_{ij}$) jeweils für eine Mehrzahl von Kombinationen von Teildatensätzen ($s_{11}$, $s_{12}$, ..., $s_{1L}$), ($s_{21}$, $s_{22}$, ..., $s_{2L}$) von in einem Pufferspeicher (11, 12) gespeicherten Datensätzen ($s_1$, $s_2$) des ersten und zweiten Signals berechnet und den jeweils größten der für die Kombinationen erhaltenen Kreuzkorrelationskoeffizienten ($CC_{ij}$) an die Logikschaltung (15) ausgibt,
    **dadurch gekennzeichnet, dass** die Logikschaltung (15) einen Zähler (21) aufweist, der jedes Mal, wenn der vom Komparator (14) gelieferte Ähnlichkeitsgrad einen ersten Grenzwert übersteigt, inkrementiert wird und der mit einer festgelegten Periode dekrementiert wird, und dass die Logikschaltung (15) die zwei Sender als identisch erfasst, wenn der Stand des Zählers (21) einen zweiten Grenzwert (23) übersteigt.

11. Vorrichtung nach Anspruch 10, **gekennzeichnet durch** den Pufferspeicher (11, 12) zum Aufnehmen eines Satzes ($s_1$, $s_2$) von Abtastwerten der zwei transformierten Signale, die den zeitlichen Verlauf der Signale jeweils über eine Zeitspanne charakterisieren, die wenigstens so groß ist wie eine erwartete maximale Zeitverschiebung zwischen den Signalen.

12. Vorrichtung nach Anspruch 10 oder 11, **dadurch gekennzeichnet, dass** der Komparator (14) ein Tiefpassfilter (18) zum Tiefpassfiltern des an die Logikschaltung (15) auszugebenden Kreuzkorrelationskoeffizienten ($CC_{ij}$) umfasst.

13. Vorrichtung nach einem der Ansprüche 10 bis 12, **dadurch gekennzeichnet, dass** dem Komparator (14) ein Bandpassfilter, insbesondere ein Tiefpassfilter (7), für die zwei transformierten Signale vorgeschaltet ist.

14. Vorrichtung nach einem der Ansprüche 10 bis 13, **dadurch gekennzeichnet, dass** sie Teil eines Empfängers für Rundfunk- oder Fernsehsignale ist.

**Claims**

1. Method for recognizing two transmitters having the same program content, which comprises the following steps:

   a) converting two signals received by the transmitters to the baseband,
   b) calculating a similarity degree of the temporal courses of the two converted signals,
   c) recognizing two transmitters as identical if the calculated similarity degree exceeds a limit value,

   wherein, before carrying out step c), the calculated similarity degree ($CC_{ij}$) is subjected to an averaging over a plurality of repetitions of step b),
   **characterized in that**, in step c), each time, when the similarity degree ($CC_{ij}$) exceeds a first limit value, a counter (21) is incremented, **in that** the counter (21) is decremented with a fixed period, and **in that** two transmitters are recognized as identical only if the value of the counter (21) exceeds a second limit value (23).

2. Method according to Claim 1, **characterized in that** the calculation of the similarity degree is carried out by calculating a cross correlation coefficient ($CC_{ij}$) of the temporal courses of the converted signals.

3. Method according to Claim 1 or 2, **characterized in that**, in step b), a plurality of values of the similarity degree ($CC_{ij}$) is calculated on the basis of different time lags between the received signals, and the largest value obtained in step c) is used.

4. Method according to Claim 3, **characterized in that** the plurality of values of the similarity degree ($CC_{ij}$) are determined in each case based on a set of sampling values ($s_1$, $s_2$) of the two converted signals, which characterize the temporal course of the signals in each case over a time span that is at least as large as an expected maximum time lag between the signals.

5. Method according to Claim 4, **characterized in that** the two sets ($s_1$, $s_2$) are subdivided into a plurality of partial sets ($s_{11}$, $s_{12}$, ..., $s_{1L}$; $s_{21}$, $s_{22}$, ..., $s_{2L}$) and each similarity degree ($CC_{ij}$) is obtained by calculating a similarity degree of a partial set ($s_{11}$, $s_{12}$, ..., $s_{1L}$) of the first signal and of a partial set ($s_{21}$, $s_{22}$, ..., $s_{2L}$) of the second signal.

6. Method according to one of the previous claims, **characterized in that**, before step b), a band pass filtering of the converted signals is carried out.

7. Method according to Claim 6, **characterized in that** the band pass filtering is a low pass filtering.

8. Method according to Claim 6 or 7, **characterized in that** the signals in step b) are processed at a sampling rate that corresponds to the width of the passband of the filtering.

9. Method according to Claim 1, **characterized in that** the averaging is a low pass filtering.

10. Device for recognizing two transmitters having the same program content, which comprises:

    a demodulator (2, 3) for converting two of the signals received by the transmitters to the baseband,
    a comparator (14) for calculating a similarity degree between the temporal courses of the two converted signals, and
    a logic circuit (15) for recognizing two transmitters as identical if the calculated similarity degree exceeds a limit value,
    wherein the comparator (14) is a computing circuit (16) for calculating cross correlation coefficients ($CC_{ij}$) of the temporal courses of the converted signals, and it calculates cross correlation coefficients ($CC_{ij}$) in each case for a plurality of combinations of partial data sets ($s_{11}$, $s_{12}$, ..., $s_{1L}$, ($s_{21}$, $s_{22}$, ..., $s_{2L}$) of data sets ($s_1$, $s_2$) of the first signal and of the second signal, which are stored in a buffer memory (11, 12, and outputs the respective largest cross correlation coefficient ($CC_{ij}$) obtained for the combinations to the logic circuit (15)
    **characterized in that** the logic circuit (15) comprises a counter (21), which is incremented in each case when the similarity degree supplied by the comparator (14) exceeds a first limit value, and which is decremented with a fixed period, and **in that** the logic circuit (15) recognizes the two transmitters as identical if the value of the counter (21) exceeds a second limit value (23).

11. Device according to Claim 10, **characterized by** the buffer memory (11, 12) for receiving a set ($s_1$, $s_2$) of sampling

values of the two converted signals, which characterize the temporal course of the signals in each case over a time span which is at least as large as an expected maximum time lag between the signals.

12. Device according to Claim 10 or 11, **characterized in that** the comparator (14) includes a low pass filter (18) for low pass filtering of the cross correlation coefficients ($CC_{ij}$) to be output to the logic circuit (15).

13. Device according to one of Claims 10 to 12, **characterized in that** a band pass filter, in particular a low pass filter (7), for the two converted signals is located upstream of the comparator (14).

14. Device according to one of Claims 10 to 13, **characterized in that** it is part of a receiver for radio and television signals.

**Revendications**

1. Procédé de reconnaissance de deux émetteurs comportant le même contenu de programmes, qui comprend les étapes suivantes :

   a) conversion de deux signaux reçus par les émetteurs vers la bande de base,
   b) calcul d'un degré de similitude des courses temporelles des deux signaux convertis,
   c) reconnaissance de deux émetteurs comme identiques si le degré de similitude calculé dépasse une valeur limite,

   où, avant de procéder à l'étape c), le degré calculé de similitude ($CC_{ij}$) est soumis à un calcul de moyenne sur une pluralité de répétitions de l'étape b),
   **caractérisé en ce qu'**à l'étape c), à chaque fois, lorsque le degré de similitude ($CC_{ij}$) dépasse une première valeur limite, un compteur (21) est incrémenté, **en ce que** le compteur (21) est décrémenté selon une période fixe, et **en ce que** deux émetteurs sont reconnus comme identiques uniquement si la valeur du compteur (21) dépasse une deuxième valeur limite (23).

2. Procédé selon la revendication 1, **caractérisé en ce que** le calcul du degré de similitude est effectué par calcul d'un coefficient de corrélation croisée ($CC_{ij}$) des courses temporelles des signaux convertis.

3. Procédé selon la revendication 1 ou 2, **caractérisé en ce qu'**à l'étape b), une pluralité de valeurs de degré de similitude ($CC_{ij}$) est calculée en fonction des différents retards entre les signaux reçus et où l'on utilise la valeur la plus grande obtenue à l'étape c).

4. Procédé selon la revendication 3, **caractérisé en ce que** la pluralité de valeurs du degré de similitude ($CC_{ij}$) est déterminée dans chaque cas en fonction d'un ensemble de valeurs d'échantillonnage ($s_1$, $s_2$) des deux signaux convertis, qui caractérisent la course temporelle des signaux dans chaque cas au cours d'une durée qui est au moins aussi grande qu'un retard maximal attendu entre les signaux.

5. Procédé selon la revendication 4, **caractérisé en ce que** les deux ensembles ($s_1$, $s_2$) se divisent en une pluralité d'ensembles partiels ($s_{11}$, $s_{12}$, ..., $s_{1L}$; $s_{21}$, $s_{22}$, ..., $s_{2L}$) et où chaque degré de similitude ($CC_{ij}$) s'obtient par calcul d'un degré de similitude d'un ensemble partiel ($s_{11}$, $s_{12}$, ..., $s_{1L}$) du premier signal et d'un ensemble partiel ($s_{21}$, $s_{22}$, ..., $s_{2L}$) du deuxième signal.

6. Procédé selon l'une des revendications précédentes, **caractérisé en ce que**, avant l'étape b), un filtrage de bande passante des signaux convertis a lieu.

7. Procédé selon la revendication 6, **caractérisé en ce que** le filtrage de bande passante est un filtrage passe-bas.

8. Procédé selon la revendication 6 ou 7, **caractérisé en ce que** les signaux de l'étape b) sont traités à une cadence d'échantillonnage qui correspond à la largeur de la bande passante du filtrage.

9. Procédé selon la revendication 1, **caractérisé en ce que** le calcul de moyenne est un filtrage passe-bas.

10. Dispositif de reconnaissance de deux émetteurs ayant le même contenu de programmes, qui comprend :

un démodulateur (2, 3) permettant de convertir deux des signaux reçus par les émetteurs vers la bande de base,
un comparateur (14) permettant de calculer un degré de similitude entre les courses temporelles des deux signaux convertis, et
un circuit logique (15) permettant de reconnaître deux émetteurs comme identiques si le degré calculé de similitude dépasse une valeur limite,
dans lequel le comparateur (14) est un circuit de calcul (16) permettant de calculer des coefficients de corrélation croisée ($CC_{ij}$) des courses temporelles des signaux convertis, et où il calcule des coefficients de corrélation croisée ($CC_{ij}$) dans chaque cas pour une pluralité de combinaisons d'ensembles de données partielles ($s_{11}$, $s_{12}$,..., $s_{1L}$), ($s_{21}$, $s_{22}$, ..., $s_{2L}$) d'ensembles de données ($s_1$, $s_2$) du premier signal et du deuxième signal, qui sont enregistrées dans une mémoire tampon (11, 12 et les sorties du coefficient respectif le plus grand de corrélation croisée ($CC_{ij}$) obtenu pour les combinaisons du circuit logique (15)
**caractérisé en ce que** le circuit logique (15) comprend un compteur (21) qui est incrémenté dans chaque cas lorsque le degré de similitude indiqué par le comparateur (14) dépasse une première valeur limite, et qui est décrémenté selon une période fixe, et **en ce que** le circuit logique (15) reconnaît les deux émetteurs comme identiques si la valeur du compteur (21) dépasse une deuxième valeur limite (23).

11. Dispositif selon la revendication 10, **caractérisé par** la mémoire tampon (11, 12) permettant de recevoir un ensemble ($s_1$, $s_2$) de valeurs d'échantillonnage des deux signaux convertis, qui caractérisent la course temporelle des signaux dans chaque cas au cours d'une durée qui est au moins aussi grande qu'un retard maximal attendu entre les signaux.

12. Dispositif selon la revendication 10 ou 11, **caractérisé en ce que** le comparateur (14) comprend un filtre passe-bas (18) destiné à un filtrage passe-bas des coefficients de corrélation croisée ($CC_{ij}$) à sortir vers le circuit logique (15).

13. Dispositif selon l'une des revendication 10 à 12, **caractérisé en ce qu'**un filtre de bande passante, en particulier un filtre passe-bas (7) pour les deux signaux convertis, se trouve en amont du comparateur (14).

14. Dispositif selon l'une des revendication 10 à 13, **caractérisé en ce qu'**il fait partie d'un récepteur pour des signaux de radio et de télévision.

# Fig. 1

# Fig. 2

# Fig. 3

$s_1(k-N)$   $s_1(k-3N)$ ...

$s_1(k)$   $s_1(k-2N)$   ...   $s_1(k-(L-1)N)$

$s_1(k-LN)$

$S_{11}$   $S_{12}$   $S_{13}$   $S_{14}$   $S_{15}$   ...   $S_{1L}$

$s_2(k)$

$S_{21}$   $CC_{11}$   $CC_{12}$   $CC_{13}$   $CC_{14}$   $CC_{1L}$

$s_2(k-N)$

$S_{22}$   $CC_{21}$

$s_2(k-2N)$

$S_{23}$

$s_2(k-3N)$

$s_2(k-(L-1)N)$

$S_{2L}$   $CC_{L1}$   ...

$s_2(k-LN)$

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3203591 A1